# EUROPEAN PATENT SPECIFICATION

(11) **EP 0 367 728 B1**
(45) Date of publication and mention of the grant of the patent: **31.08.1994**
(21) Application number: 89830400.1
(22) Date of filing: 19.09.1989
(51) Int. Cl.: G01R 31/00

(54) **A system for the automatic testing, preferably on a bench, of electronic control systems which are intended to be fitted in vehicles**
System zur automatischen Prüfung, vorzugsweise auf einer Testbank, von elektronischen Steuersystemen, die zur Montage in Fahrzeuge bestimmt sind
Système pour le test automatique, de préférence sur un banc, de systèmes électroniques de commande qui sont destinés à être installés dans des véhicules

(30) Priority: 18.10.1988 IT 6793288
(43) Date of publication of application: 09.05.1990
(73) Proprietor: FIAT AUTO S.p.A., 10135 Torino (IT)
(72) Inventor: Raviglione, Cesare, I-10133 Torino (IT); Gallo, Antonino, I-10154 Torino (IT); Di Lago, Vincenzo, I-10147 Torino (IT)
(74) Representative: Bosotti, Luciano

(56) References cited:
- EP-A- 0 039 122
- EP-A- 0 231 607
- GB-A- 2 055 214
- US-A- 3 630 076
- US-A- 3 789 658
- US-A- 3 890 836
- US-A- 4 425 791
- US-A- 4 517 839
- US-A- 4 517 839
- IBM TECHNICAL DISCLOSURE BULLETIN, vol. 31, no. 3, August 1988, pages 428-431,New York, US; "Automobile electronics best diagnostic instrument andcommunications circuit"
- IDEM
- IBM TECHNICAL DISCLOSURE BULLETIN, vol. 26, no. 12, May 1984, pages 6289-6290,New York, US; M.L. BULLER et al.: "Automated thermal test system"

## Description

The present invention relates in general terms to testing (checking) systems used for the automatic testing of the characteristics and/or operating conditions of electrical and/or electronic circuits.

More specifically, the invention has been developed for possible application in the automotive sector in order to provide an automatic testing station which can stimulate electronic control units (E.C.U.s) of vehicles by simulating, during bench testing, the conditions present in vehicles in order to check whether or not they are operating correctly.

In order fully to satisfy the requirements of use, such an automatic testing system must offer the possibility of preparing functional tests for a generic control unit in the laboratory without the need necessarily to carry out tests on the vehicle, thus avoiding the following disadvantages:
- practical difficulties in preparing for the test (availability of the prototype vehicle, non-optimal operation of the prototype...),
- testing which is not always exhaustive (difficulties in the generation of anomalous conditions, possibility of damaging parts of the vehicle involved in the test), and
- risks to the testers in promoting the malfunctioning of devices of the vehicle.

The advantages to be provided are therefore:
- the ability to test a generic control unit rapidly,
- the ability to reproduce the tests in a predetermined sequence,
- the ability to carry out tests on control units under different climatic conditions by the modification of temperature and humidity, and
- the immediate availability of documentation relating to the results of the tests carried out.

From US-A-4 517 839 an off-nighway vehicle systems simulator and control panel testing apparatus is known, wherein predetermined signals for stimulating the system under test are generated and the signals output by the system under test as a result of the application of the stimulation signals are decoded and analysed. Such a system is designed in order to allow step-by-step testing.

Also, from GB-A-2 055 214 apparatus for testing a control system for automotive vehicles is known, wherein signals from various sensors which sense the operational state of an internal combustion engine or dummy signals from a dummy signal generator are supplied to a control unit to generate respective control signals.

The object of the present invention is therefore to provide a testing system which achieves the above advantages while avoiding the disadvantages described above.

According to the present invention, this object is achieved by a system having the characteristics set forth in Claim 1.

In brief, as regards the arrangement of its circuits (hardware), the system according to the invention can be divided into two functionally-interconnected subsystems, that is:
- a subsystem for stimulating the control unit under test, and
- a subsystem for decoding and analysing messages transmitted by the control unit under test through a serial diagnostic channel.

The two subsystems are controlled by a central computer dedicated to the organisation, synchronising and checking of the tests generated for the bench stimulation of the electronic control units. The specification of the tests to be carried out is defined by the operator by means of a high-level software interface.

The instrumentation necessary for making up the stimulation subsystem is preferably selected on the basis of signals characterised during the feasibility studies, which may be classified into:
- repetitive analog signals of arbitrary form which are variable in frequency and in amplitude (for example signals indicative of the passage through top dead centre, of the phase of the engine etc...),
- non-repetitive analog signals of arbitrary form, which are variable in amplitude and in frequency (for example signals indicative of the vacuum in the intake manifold, of the position of the carburettor throttle valve,...),
- on/off signals which are variable in amplitude or in frequency (for example steering sensor, accelerometer...), and
- signals which simulate resistive transducers (for example NTC or PTC transducers ...).

The result of the test can preferably be determined by the acquisition of the messages which the central control unit sends to the decoding system.

This dialogue enables information to be exchanged between the stimulation and decoding subsystems so as to enable the events constituting the test of the control unit to be synchronised.

The software of the system according to the invention preferably also enables the operator to interact by means of a selection menu guided by means of function keys.

The programmes are written in a high-level language and are made of open modules which allow modification and possibly additions. The procedures for testing the various control units are organised in testing sequences, each of which serves to check that individual anomalies are detected correctly.

The tests implemented can be scanned at will and their succession achieves the complete or partial testing of the control unit under test. The programme provides for the production from time to time by the dedicated instrumentation of the signals necessary to stimulate the control unit during the execution of the required test and the simultaneous analysis of the information available from the diagnostic channel.

The specification of a test refers to a data base of the elemental signals necessary for the complete functioning of the control unit.

The input or output signals of the control unit are usually characterised by the following information:
- a single identification of the signal,
- the instrument which is to generate or check the signal, and
- a description of the signal, defined as the set of information necessary for the instrument to generate or check the signal correctly.

The invention will now be described, purely by way of non-limiting example, with reference to the appended drawings, which are block diagrams representing respectively:
Figure 1, the general architecture of the system according to the invention,
Figure 2, an enlarged detail of the architecture,
Figure 3, a possible circuit for implementing the system according to the invention, and
Figure 4, a diagram of the paths and switching of the signals within the circuit of Figure 3.

As already stated above, the system according to the invention, generally indicated 1 in the appended drawings, is intended to enable the automatic checking of electronic control units (E.C.U.s) which control the operation of electrical and/or electronic circuits in motor vehicles. This is achieved by means of functional tests carried out on a test bench, that is, in general, before the fitting of the control unit in the vehicle and possibly after its removal from the vehicle.

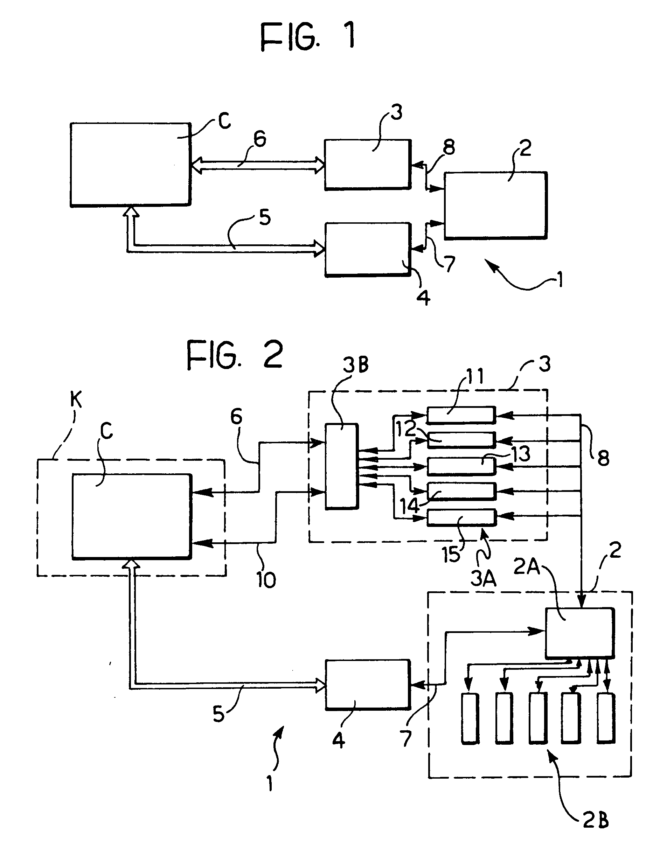

In Figures 1 to 4, such a control unit, which may be of any type known in the art, is generally indicated C.

The system 1 is composed essentially of a control processor or computer 2 (typically a minicomputer, or possibly an advanced microprocessor) which coordinates the operation of two subsystems constituted respectively by:
- a subsystem 3 for stimulating the control unit C, and
- a subsystem 4 for decoding and analysing the messages transmitted by the control unit C under test.

In the embodiment currently preferred, to which the present description relates, the decoding and analysis subsystem 4, which is connected to the control unit through a serial channel 5 which acts as the diagnostic line, corresponds essentially to the solution described in the previous European Patent Application No. 0 286 648 in the name of the same Applicant.

The structure and functions of the subsystem 4, which does not itself constitute a specific subject of the present invention - except as regards its connection to and dialogue with other components of the system 1 - will not therefore be described in detail herein.

The important element of the system 1 of the invention is the presence of the stimulation subsystem 3 whose function is mainly to apply signals to the control unit C during its testing on the bench, which signals reproduce, as faithfully as possible, the signals which the control unit C will receive during its operation in a motor vehicle so that the circuit integrity and operation of the control unit C can consequently be checked, even as regards its reactions to anomalous operating situations (warning routines, etc.).

As already indicated above, the signals generated by the subsystem 3 for application to the control unit C through a communication line 6 consist essentially of:
- logic signals (on/off) which are variable in amplitude and in frequency,
- repetitive analog signals of arbitrary form which are variable in frequency and in amplitude,
- non-repetitive analog signals of arbitrary form which are variable in amplitude and in frequency, and
- signals which simulate resistive transducers.

As regards the communications between the control computer 2 and the subsystems 3 and 4, a standard protocol of the RS 232 C type may, for example, be used for communication with the diagnostic decoding subsystem 4 and a GP-IB bus may be used for communication with the stimulating and measuring subsystem 3.

In general, the checking (or the testing in general) of the control unit C is effected whilst it is in an air-conditioned cell K so that environmental conditions (pressure, temperature, humidity, possible vibrations, etc) prevailing in the cell K are variable selectively according to known criteria with the use of actuators B of known type such as vacuum pumps/compressors, heating and/or cooling elements etc.).

For this purpose, the actuators B are controlled by the computer 2 through a line 9.

One or more actuators to which the control unit is functionally connected during use are indicated T. These may also be placed in the cell K and tested by means of a line 10 connected to the subsystem 3.

According to a widely-known solution, the computer 2 which controls the system is arranged, as shown schematically in Figure 2, in the form of a central unit 2A with a plurality of associated peripherals 2B such as, for example, a video screen with a keyboard, a so-called "mouse", a printer, a graphics tablet, a device for drawing graphs ("plotter"), various external memories, etc...

The subsystem 3 enables input sensors to be simulated and the signals output by the electronic control unit C to control the actuators T associated therewith in normal use to be checked simultaneously.

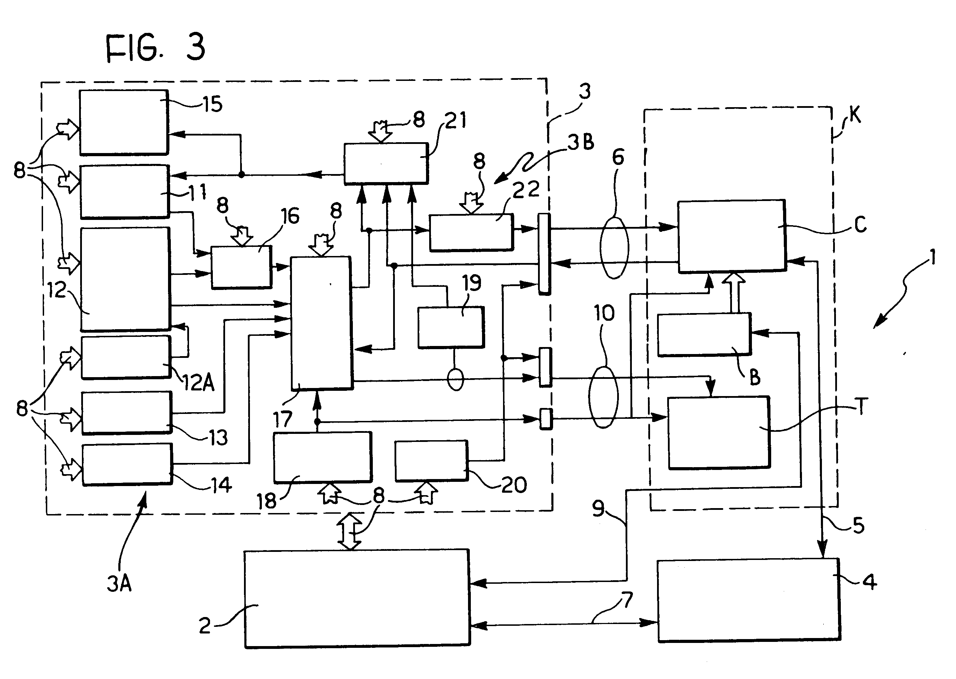

In general terms (as shown generally in Figures 2 and in greater detail in Figures 3 to 4) the subsystem 3 consists essentially of a group of stimulation and measurement moduli generally indicated 3A, with an associated group of circuits 3B (amplifiers, adaptors, relays, multiplexers, etc.) which act as an interface for communication with the control unit C under test and the cell K in which the latter is situated through the lines 6 and 10.

The group of modules 3A thus also includes circuit elements which enable measurements to be made and, in particular, the functions of:
- the simultaneous display of the input and output signals from and to the electronic control unit C,
- the partial or total acquisition of these signals, and
- the measurement of the signals generated by the control unit C.

In one possible embodiment, the group of modules 3A includes:
- a multichannel magnetic recorder 11 such as, for example, a Sony KS616U recorder or the like,
- a waveform generator 12 which, in dependence on signals received on the bus 8 from the computer, can generate signals having sinusoidal, triangular, square, pulsed, digitally-coded waveforms or any other arbitrary wave form generated by any known method of synthesis; the generator 12 may be constituted, for example, by a bank of signal generators with digital control, such as the Hewlett-Packard generators HP3245, HP44726A and HP44724A. A further circuit 12A constituted, for example, by a wave-form generator HP44725A is associated with the latter circuit so as to generate amplitude and frequency modulation waveforms,
- one or more programmable supplies 13, such as a two-channel programmable supply HP6622A,
- a circuit 14 which simulates the resistance signals output by a resistive transducer such as an NTC or PTC transducer (negative or positive temperature coefficient transducer), and
- a measurement section 15, including, for example, one or more oscilloscopes (for example HP54501), one or more frequency meters (for example HP53708 and/or HP44715A) as well as one or more voltmeters (for example HP 44702A).

The exact way in which the modules 3A are connected to the lines 6 and 10 will be described in greater detail below.

The magnetic recorder 11 is used mainly in order:
- to record its input of all the signals input and output by and to the electronic control unit C, and
- to apply to the control unit C itself, prerecorded signals which have been synthesised (constructed) in the laboratory, or possibly detected in a motor vehicle under particular operating conditions: in this connection, the magnetic recorder 11 can cooperate with or even replace the generators of the group 12 to 14 for generating arbitrary wave forms.

The main function of the generators 12 to 14 is to produce the signals necessary to stimulate the control unit C under test. The individual components (for example the commercially available components explicitly referred to above) have resident intelligence and are therefore able to process test sequences automatically after they have been instructed and synchronised by the computer 2.

The autonomy of the generators 12 to 14 enables the computer 2 to concentrate its activities on the real-time analysis of the results of the tests taking place. In other words, in an initial operating phase of the system 1, the computer 2 instructs the various generators 12 so that they can generate the signals for stimulating the control unit C (according to a predetermined sequence). The computer 2 can then concentrate its attention on the monitoring and/or diagnostic signals, particularly those which it receives from the decoding system 4 through the line 7, whilst the intelligence resident in the circuits 12 enables them to generate the signals autonomously.

The instructions conveyed from the computer 2 to the circuits 12 to 14 (and possibly also to the recorder 11 when it is acting as a source of prerecorded signals) correspond to the instructions received in a high-level language from the operator by means of one or more interfaces.

In general the instructions may concern:
- the criteria for generating the signals, that is the selection of the generator or generators to be activated, the path which the signals must follow with the assignation of the respective output line (in this connection see the detailed description, given below,of the criteria by which the lines 6 and 10 are connected), the construction of a library of signals,
- the selection of the signals to be detected, that is, the definition of the input line, the paths the signals must follow, the instruments 15 to be activated, the characteristics and tolerances of the expected signals, the possible composition of a library of input signals,
- the description of the tests to be carried out with the selection and synchronisation of the signals which are to be generated or measured in order to execute the test, the definition of the development of the signals generated with time, the definition of the timing and manner of checking of the signals measured, the possible "filing" of the test described, with the possibility of automatic retrieval, and
- the construction of testing sequences, possibly with the selection and combination of several tests which have already been filed.

As already stated, dialogue with the control computer can take place through any of the peripherals associated therewith (keyboard, video, tablet, mouse, hard disc, floppy disc, printer, plotter, etc.).

An input selector circuit piloted by the computer 2 through the bus 8 is indicated 16. The selector 16 (for example an HP 34503B component) enables the individual selection of the channels coming from the magnetic recorder 11, or those coming from the wave form generators and the application of the signals selected to the control unit C.

In particular the selector 16 enables the signals produced by the generators 12 to 14, the signals prerecorded in the recorder 11, or combinations thereof, to be applied to the control unit C.

Reference 17 indicates a connection matrix which, still under the control of the computer 2 through the line 8, as well as supervising the switching of the signals generated in the modules 11 to 14 to the lines 6 and 10, can also act as a generator of disturbances, such as:
- short-circuiting to the supply voltage (battery),
- short-circuiting to earth, and
- open circuit

in all the signals coming from the modules 11 to 14 which are intended to be transferred to the control unit C through the line 6) as well as, optionally, in the signals generated by the electronic supply unit C for the piloting of the actuators T associated therewith. The latter signals are transferred to the control unit C and the actuators T of the cell K through the line 10. For this purpose the matrix 17 may include several HP 34510B and HP 34511M modules (switching of generator signals).

The use is also envisaged of a programmable power supply 18 (for example an HP 6032 component) which can simulate the supply voltage of the electronic control unit C and its actuators T. In particular, the supply 18 enables variations in this voltage to be simulated so that the electronic control unit C can be tested to check that it operates correctly when it is supplied within the limits of the range of values in which it must operate.

One or more probes, indicated 19, are connected to the line 10 for measuring the behaviour of the current in the actuators T during the tests, enabling their operation to be checked under different working conditions.

Finally, a bank of relays or controllable electronic switches (for example an HP 44725A module) is indicated 20 and enables the various switches or deviators at the input of the electronic control unit C to be simulated so as to activate or de-activate the electronic circuitry constructed to simulate abnormalities in the actuators.

Turning now to a description of the elements which act as the interface (3B), a multiplexer (for example with 64 channels - HP 44725A and/or HP 34511B components) indicated 21 is connected to the switching matrix 17 (that is the generators 12 to 14) and to the actuators, as well as to the probes 19, and has the function of switching the signals which are travelling from and to the control unit C on the line 6 to the measurement section 15 and to the magnetic recorder 11.

Finally, a bank of amplifiers-adaptors is indicated 22 whose function is to adjust the electrical levels of the signals generated for simulating the sensors of the electronic control unit.

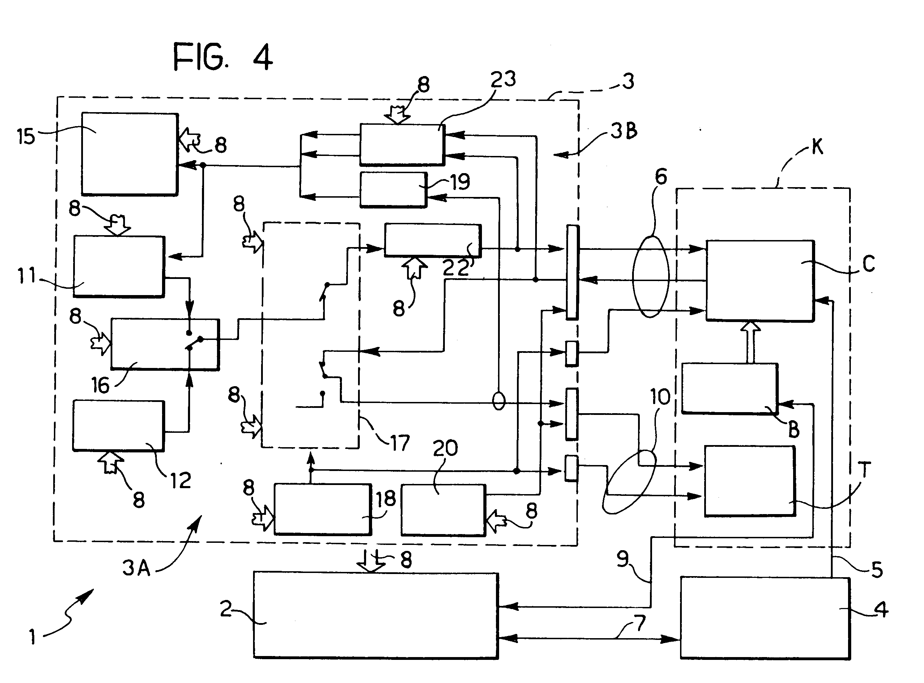

Figure 4 indicates a typical signal path and switching diagram showing that it is possible to select a simulating signal, or a signal from the recorder or from the function generator and to simulate breakdowns (open circuits, short circuits to the battery or to earth).

## Claims

1. A system for the automatic bench testing of electronic control systems (C), for motor vehicles, in conjunction with a test bench (K) and respective associated actuators (T), including:
- means (3) independent of the motor vehicle, for generating predetermined signals for stimulating the system (C) under test,
- connection means (17) independent of the motor vehicle, for conveying the stimulation signals to the system (C) under test,
- means (4) for decoding and analysing the signals (10) output by the system (C) under test as a result of the application of the stimulation signals,
- a processing circuit (2) independent of the motor vehicle, which controls the means (3) for generating stimulation signals and the decoding and analysing means (4) to operate according to selectively predetermined sequences,
- measuring means (15) including elements selected from the group consisting of voltmeters, frequency meters and oscilloscopes, for detecting the signals output by the system (C) under test as a result of the application of the stimulation signals, wherein:
- said connection means (17) are able to apply to at least one of the stimulation signals and said actuators (T) disturbances which correspond to at least one of the following phenomena:
- short circuiting to the battery,
- short circuiting to the earth, and
- open circuit.

2. A system according to Claim 1, the means (3) for generating stimulation signals being arranged to generate signals selected from the group consisting of:
- repetitive analog signals of arbitrary form which are variable in frequency and in amplitude,
- non-repetitive analog signals of arbitrary form which are variable in amplitude and in frequency,
- logic signals which are variable in amplitude or in frequency, and
- signals which simulate the variation of a resistance in resistive components with a temperature coefficient other than zero (NTC, PTC).

3. A system according to any one of the preceding claims, including a recording module (11) for storing at least one of the signals output by the system (C) under test as a result of the application of the stimulation signal and/or for storing at least one predetermined stimulation signal to be applied to the system (C) under test.

4. A system according to any one of Claims 1 to 3 including at least one supply module (13, 18) for generating a supply voltage for application to the electronic system (C) under test, the voltage of the supply being variable selectively (8) to check that the system (C) under test functions correctly when the supply voltage varies.

5. A system according to any one of the preceding claims, including level-adjustment means (22) which operate on the stimulation signals and/or on the signals output by the system (C) under test as a result of the stimulation signals.

6. A system according to any of the preceding claims, applicable to the testing of control systems (C) with respective associated actuators (T), the system including probe means (19) for detecting the electrical consumption of the actuators (T) during the testing of the system (C).

7. A system according to Claim 6, the probe means comprising current probes (19).

8. A system according to Claim 2, the means (3A) for generating the stimulation signals comprising signal generators (12) which have resident intelligence and which can generate stimulation signals in sequence autonomously as a result of initiating instructions received from the processing circuit (2) so that, during testing, the processing circuit (2) can operate primarily on the signals output by the system (C) under test as a result of the application of the stimulation signals.

9. A system according to any one of the preceding claims, which can be used in conjunction with an air conditioned cell (K) for the application of selectively-determined environmental conditions to the system (C) under test, the air-conditioned cell (K) carrying respective associated air-conditioning means (B), the system including means (2, 9) for operating the air-conditioning means (B) in coordination with the means (3) for generating the stimulation signals and/or the means (4) for decoding and analysing the signals output by the system (C) under test as a result of the application of the stimulation signals.

## Patentansprüche

1. System zum automatischen Prüfstandtesten elektronischer Steuersysteme (C) für Kraftfahrzeuge in Verbindung mit einem Testprüfstand (K) und entsprechenden zugeordneten Stellgliedern (T), umfassend:
- von dem Kraftfahrzeug unabhängige Mittel (3) zum Erzeugen vorbestimmter Signale zum Anregen des im Test befindlichen Systems (C),
- von dem Kraftfahrzeug unabhängige Verbindungsmittel (17) zum Übermitteln der Anregungssignale zu dem im Test befindlichen System (C),
- Mittel (4) zum Decodieren und Analysieren der von dem im Test befindlichen System (C) infolge des Anlegens der Anregungssignale ausgegebenen Signale (10),
- einen von dem Kraftfahrzeug unabhängigen Verarbeitungsschaltkreis (2), welcher die Mittel (3) zum Erzeugen von Anregungssignalen und die Decodier- und Analysier-Mittel (4) derart steuert, daß sie gemäß wahlweise vorbestimmten Abfolgen arbeiten,
- Meßmittel (15), die Elemente umfassen, die aus der aus Voltmetern, Frequenzmessern und Oszilloskopen bestehenden Gruppe ausgewählt sind, zum Erfassen der von dem im Test befindlichen System (C) infolge des Anlegens der Anregungssignale ausgegebenen Signale, wobei:
- die Verbindungsmittel (17) in der Lage sind, auf die Anregungssignale oder/und die Stellglieder (T) Störungen aufzubringen, die wenigstens einem der folgenden Ereignisse entsprechen:
- Kurzschluß zur Batterie,
- Kurzschluß zu Masse und
- offene Schaltung.

2. System nach Anspruch 1, wobei die Mittel (3) zum Erzeugen von Anregungssignalen zur Erzeugung von Signalen ausgebildet sind, die aus der Gruppe ausgewählt sind, die besteht aus:
- sich wiederholende Analogsignale beliebiger Form, die in Frequenz und Amplitude veränderlich sind,
- sich nicht wiederholende Analogsignale beliebiger Form, die in Amplitude und Frequenz veränderlich sind,
- logische Signale, die in Amplitude oder Frequenz veränderlich sind, und
- Signale, die die Variation eines Widerstands eines Widerstandsbauelements mit einem von Null verschiedenen Temperaturkoeffizienten (NTC, PTC) simulieren.

3. System nach einem der vorhergehenden Ansprüche, umfassend ein Aufzeichnungsmodul (11) zum Speichern wenigstens eines der von dem im Test befindlichen System (C) infolge des Anlegens des Anregungssignals ausgegebenen Signale und/oder zum Speichern wenigstens eines an das im Test befindliche System (C) anzulegenden vorbestimmten Anregungssignals.

4. System nach einem der Ansprüche 1 bis 3, umfassend wenigstens ein Versorgungsmodul (13, 18) zum Erzeugen einer Versorgungsspannung zum Anlegen an das im Test befindliche elektronische System (C), wobei die Versorgungsspannung wahlweise (8) veränderlich ist, um zu überprüfen, daß das im Test befindliche System (C) bei Änderung der Versorgungsspannung korrekt arbeitet.

5. System nach einem der vorhergehenden Ansprüche, umfassend Pegel-Einstellmittel (22), die auf die Anregungssignale und/oder die von dem im Test befindlichen System (C) infolge der Anregungssignale ausgegebenen Signale einwirken.

6. System nach einem der vorhergehenden Ansprüche, anwendbar auf das Testen von Steuersystemen (C) mit entsprechenden zugeordneten Stellgliedern (T), wobei das System Meßstellenmittel (19) umfaßt zum Erfassen des elektrischen Verbrauchs der Stellglieder (T) während des Testens des Systems (C).

7. System nach Anspruch 6, wobei die Meßstellenmittel Strommeßstellen (19) umfassen.

8. System nach Anspruch 2, wobei die Mittel (3A) zum Erzeugen der Anregungssignale Signalgeneratoren (12) umfassen, welche residente Intelligenz aufweisen und welche infolge von einleitenden, von dem Verarbeitungsschaltkreis (2) empfangenen Instruktionen Anregungssignale selbstständig in Abfolge erzeugen können, so daß der Verarbeitungsschaltkreis (2) während des Testens hauptsächlich die von dem im Test befindlichen System (C) infolge des Anlegens der Anregungssignale ausgegebenen Signale bearbeiten kann.

9. System nach einem der vorhergehenden Ansprüche, welches in Verbindung mit einer klimatisierten Zelle (K) zum Anlegen von wahlweise bestimmten Umgebungsbedingungen an das im Test befindliche System (C) eingesetzt werden kann, wobei die klimatisierte Zelle (K) entsprechende zugeordnete Klimatisierungsmittel (B) trägt, wobei das System Mittel (2, 9) zum Betreiben der Klimatisierungsmittel (B) in Übereinstimmung mit den Mitteln (3) zum Erzeugen der Anregungssignale und/oder den Mitteln (4) zum Decodieren und Analysieren der von dem im Test befindlichen System (C) infolge des Anlegens der Anregungssignale ausgegebenen Signale betreibt.

## Revendications

1. Système pour l'essai automatique au banc de systèmes de commande électroniques (C) pour véhicules automobiles en liaison avec un banc d'essais (K) et des actionneurs (T) associés respectifs, comprenant :
- des moyens (3) indépendants du véhicule automobile, pour produire des signaux prédéterminés pour stimuler le système (C) en cours d'essai ;
- des moyens de connexion (17) indépendants du véhicule automobile, pour transmettre les signaux de stimulation au système (C) en cours d'essai ;
- des moyens (4) pour décoder et analyser les signaux (10) sortis par le système (C) en cours d'essai comme résultat de l'application des signaux de stimulation ;
- un circuit de traitement (2) indépendant du véhicule automobile, qui commande les moyens de production de signaux de stimulation (3) et les moyens de décodage et d'analyse (4) pour agir en fonction de séquences prédéterminées de manière sélective ;
- des moyens de mesure (15) comprenant des éléments sélectionnés à partir du groupe constitué de voltmètres, fréquencemètres et oscilloscopes, pour détecter les signaux sortis par le système (C) en cours d'essai comme résultat de l'application des signaux de stimulation ; dans lequel :
lesdits moyens de connexion (17) sont capables d'appliquer à au moins l'un des signaux de stimulation et desdits actionneurs (T) des perturbations qui correspondent à au moins l'un des phénomènes suivants :
- court-circuit à la batterie ;
- court-circuit à la masse, et
- circuit ouvert.

2. Système selon la revendication 1, les moyens de production de signaux de stimulation (3) étant agencés pour produire des signaux sélectionnés à partir du groupe constitué de :
- signaux analogiques répétitifs de forme arbitraire qui sont variables en fréquence et en amplitude ;
- signaux analogiques non répétitifs de forme arbitraire qui sont variables en amplitude et en fréquence ;
- signaux logiques qui sont variables en amplitude ou en fréquence ; et,
- signaux qui simulent la variation d'une résistance dans des composants résistifs avec un coefficient de température autre que zéro (NTC, PTC).

3. Système selon l'une quelconque des revendications précédentes, comprenant un module d'enregistrement (11) pour mémoriser au moins l'un des signaux sortis par le système (C) en cours d'essai comme résultat de l'application du signal de stimulation et/ou pour mémoriser au moins un signal de stimulation prédéterminé à appliquer au système (C) en cours d'essai.

4. Système selon l'une quelconque des revendications 1 à 3, comprenant au moins un module d'alimentation (13, 18) pour produire une tension d'alimentation pour application au système électronique (C) en cours d'essai, la tension de l'alimentation étant variable de manière sélective (8) pour contrôler que le système (C) en cours d'essai fonctionne correctement lorsque la tension d'alimentation varie.

5. Système selon l'une quelconque des revendications précédentes, incluant des moyens d'ajustement de niveau (22) qui agissent sur les signaux de stimulation et/ou sur les signaux sortis par le système (C) en cours d'essai comme résultat des signaux de stimulation.

6. Système selon l'une quelconque des revendications précédentes, applicable à l'essai de système de commande (C) avec des actionneurs (T) associés respectifs, le système comportant des moyens formant sondes (19) pour détecter la consommation électrique des actionneurs (T) pendant l'essai du système (C).

7. Système selon la revendication 6, les moyens formant sondes comprenant des sondes de courant (19).

8. Système selon la revendication 2, les moyens de production de signaux de stimulation (3A) comprenant des générateurs de signaux (12) qui ont une intelligence résidente et qui peuvent produire des signaux de stimulation en séquence de manière autonome, comme résultat du lancement d'instructions reçues du circuit de traitement (2) de sorte que, pendant l'essai, le circuit de traitement (2) peut fonctionner principalement sur les signaux sortis par le système (C) en cours d'essai comme résultat de l'application des signaux de stimulation.

9. Système selon l'une quelconque des revendications précédentes, qui peut être utilisé en liaison avec une cellule à air conditionné (K) pour l'application, au système (C) en cours d'essai, de conditions d'ambiance déterminées de manière sélective, la cellule à air conditionnée (K) portant des moyens de conditionnement d'air (B) associés respectifs, le système incluant des moyens (2, 9) pour mettre en oeuvre les moyens de conditionnement d'air (B) en coordination avec les moyens de production de signaux de stimulation (3) et/ou les moyens de décodage et d'analyse (4) des signaux sortis par le système (C) en cours d'essai comme résultat de l'application des signaux de stimulation.
